# EUROPEAN PATENT SPECIFICATION

(11) **EP 3 709 335 B1**
(45) Date of publication and mention of the grant of the patent: **22.06.2022**
(21) Application number: 19162182.0
(22) Date of filing: 12.03.2019
(51) Int. Cl.: H01H 71/24, H02H 7/22, H01H 39/00, H01H 79/00, H01H 83/20, H02H 3/05, H02H 3/10, H02H 3/16

(54) **EARTHING MODULE**
ERDUNGSMODUL
MODULE DE MISE À LA TERRE

(43) Date of publication of application: 16.09.2020
(73) Proprietor: ABB Schweiz AG, 5400 Baden (CH)
(72) Inventor: Gentsch, Dietmar, 40882 Ratingen (DE); Reuber, Christian, 47877 Willich (DE)
(74) Representative: Maiwald Patent- und Rechtsanwaltsgesellschaft mbH

(56) References cited:
- DE-A1- 3 311 833
- RU-C1- 2 584 548
- SU-A1- 743 099

## Description

### FIELD OF THE INVENTION

The present invention relates to a short circuit current detection device for a medium or high voltage switchgear, such as an air-insulated switchgear or a gas-insulated switchgear, to an earthing module for a medium or high voltage switchgear, and to a switchgear having such a short circuit detection device and/or earthing module.

### BACKGROUND OF THE INVENTION

RU 2 584 548 C1 relates to a device for detecting current overload of a 6-10 kV switchgear using reed switches mounted by a holder at adjustable distance to the busbar of the switchgear and at different angles to the cross-sectional plane of the busbar. The reed switches close at certain current overload conditions in the busbar, adjustable through the distance and also depending on the angles.

For the limitation of the effects of a fault arc inside a switchgear panel, it is desirable to quickly establish a stable current path from the conductor to ground, so that the fault arc is short-circuited and so quenched. To address this fast earthing systems are used. These use stored energy, for example from springs or micro gas generators, and are triggered by a control device depending on for example the magnitude of the current, the rate of rise of the current and/or the light emitted by the fault arc. The accurate measurement of the current is complex and expensive. The control device or module can therefore be expensive, and these systems are powered by auxiliary energy, which can impact the availability of the system. This further impacts the assembly of the switchgear panel due to the necessary wiring and increases costs.

There is a need to address this issue.

### SUMMARY OF THE INVENTION

Therefore, it would be advantageous to have an improved ability to detect short circuit currents caused for example by a fault arc and to limit the effects of a fault arc in a switchgear panel, hereafter referred to as switchgear.

The object of the present invention is solved with the subject matter of independent claim 1, wherein further embodiments are incorporated in the dependent claims.

### BRIEF DESCRIPTION OF THE DRAWINGS

Exemplary embodiments will be described in the following with reference to the following drawings:
Fig. 1 shows an example of a reed contact positioned relative to a conductor through which current is flowing;
Fig. 2 shows an example of a reed contact in different configurations relative to a conductor through which current is flowing;
Fig. 3 shows an example of a holder for a reed contact mounted to a conductor through which current is flowing;
Fig. 4 shows an example of a holder for a reed contact mounted to the surrounding structure of a switgear so that it is oriented to a conductor through which current is flowing;
Fig. 5 shows an example of an earthing module; and
Fig. 6 shows examples of closing thresholds of an exemplar reed contact with respect to different positions relative to a conductor through which current is flowing.

### DETAILED DESCRIPTION OF EMBODIMENTS

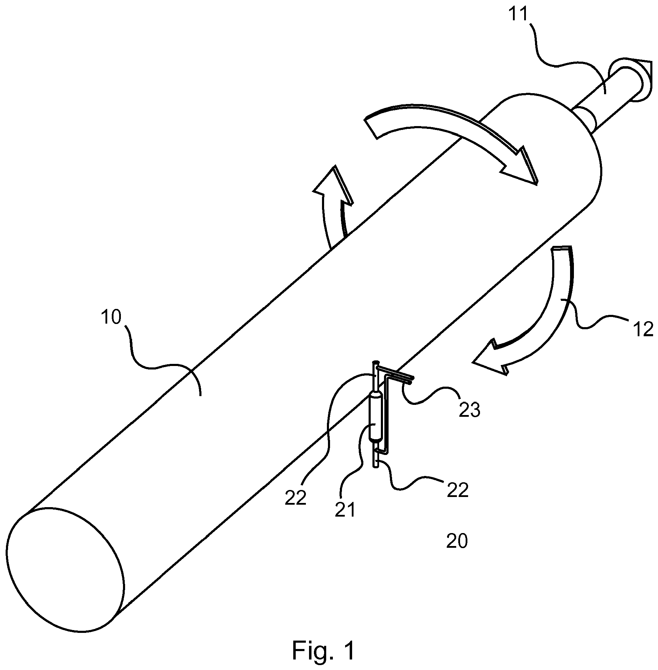

Figs. 1-6 relate to a short circuit detection device and associated earthing module for a switchgear, such as a medium or high voltage switchgear. In an example a short circuit current detection device comprises a reed contact 20, and a holder 100. The holder is configured to hold the reed contact. The holder is configured to be mounted with a defined orientation to a conductor of a switchgear. At a location where the holder is mounted the conductor has a longitudinal axis. The conductor is configured to enable a current to flow through the conductor in a direction of the longitudinal axis. The holder is configured to position the reed contact with respect to the longitudinal axis, such that when a magnitude of the current flow through the conductor exceeds a threshold current value the reed contact is configured to close. The holder comprises a plurality of holes configured to enable the reed contact to be held at a plurality of distances from the longitudinal axis.

According to an example, the threshold current value at which the reed contact is configured to close is based at least in part on an intrinsic sensitivity of the reed contact.

According to an example, the threshold current value at which the reed contact is configured to close is based at least in part on a magnitude of a distance perpendicular to the longitudinal axis at which the reed contact is positioned.

According to an example, the reed contact has a centre axis. The threshold current value at which the reed contact is configured to close is based at least in part on a magnitude of at least one angle between the longitudinal axis and the centre axis.

According to an example, an angle of the at least one angle is measured in a direction of an axis perpendicular to the longitudinal axis.

According to an example, the threshold current value at which the reed contact is configured to close is configured to increase as the magnitude of the angle increases from an orientation perpendicular to the axis perpendicular to the longitudinal axis.

According to an example, an angle of the at least one angle is measured in a direction of an axis parallel to the longitudinal axis.

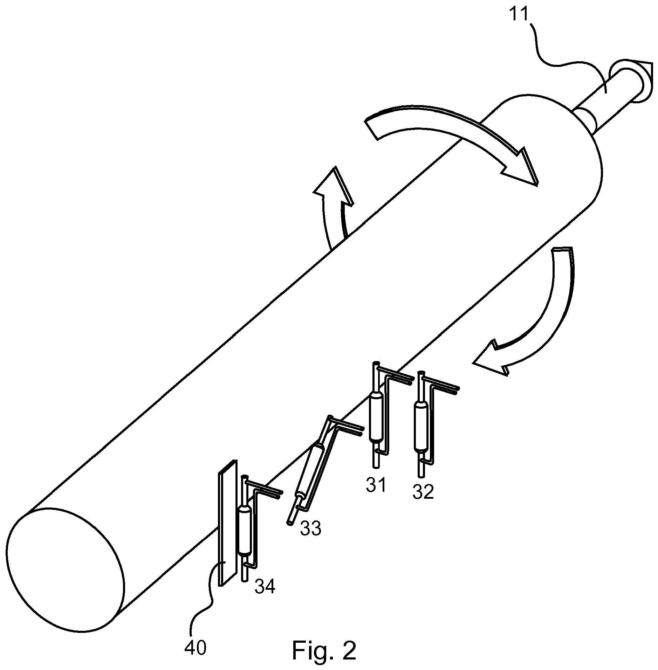

In other words, looking for example at Fig. 1 the arrow 11 shows current flow along the longitudinal axis of the conductor 10. An axis then extends perpendicular to the longitudinal axis along which current flows and extends through the reed contact 20. In Fig. 1 the centre axis of the reed contact 20 is itself perpendicular to the axis that extends perpendicular to the longitudinal axis of the conductor. The arrows around the conductor represent the magnetic flux lines, and in Fig. 1 the reed contact centre axis is shown at an orientation perpendicular to the magnetic flux. The sensitivity of the reed contact is then maximised. However, as shown in Fig. 2 the reed contact can be angled in a direction of an axis that is parallel to the longitudinal axis of the conductor and in this way the sensitivity of the reed contact is reduced, and the threshold current at which it closes increases. However, the reed contact can also be angled in the other direction, in the direction of the magnetic flux arrows, in the direction of the axis perpendicular to the longitudinal axis, and again the reed contact sensitivity is decreased and the threshold current at which it closes increases.

According to an example, the threshold current value at which the reed contact is configured to close is configured to increase as the magnitude of the angle increases from an orientation perpendicular to the axis parallel to the longitudinal axis.

According to an example, the short circuit detection device comprises a ferromagnetic shield 40. The threshold current value at which the reed contact is configured to close is based at least in part on whether the ferromagnetic shield is positioned between the reed contact and the conductor.

According to an example, the threshold current value at which the reed contact is configured to close is based at least in part on at least one characteristic of the ferromagnetic shield.

According to an example, the at least one characteristic of the ferromagnetic shield comprises one or more of: thickness, width, length, material.

The holder comprises a plurality of holes configured to enable the reed contact to be held at a plurality of distances from the longitudinal axis.

According to an example, the reed contact has a centre axis, and wherein the holder comprises a plurality of holes configured to enable the centre axis of the reed contact to be held at a plurality of angles with respect to the longitudinal axis.

According to an example, the holder comprises a plurality of slots configured to enable the optional insertion of a ferromagnetic shield between the conductor and the provided holes for holding the reed contact.

According to an example, the holder comprises means of fixation directly to the conductor so that the holder can be fixed with a defined orientation to the conductor. According to an example, the holder comprises means of fixation to the surrounding structure of the switchgear so that the holder can be fixed to the switchgear with a defined orientation to the conductor.

In an example an earthing module for a medium voltage or high voltage switchgear comprises a short circuit detection device as described above and a photovoltaic cell 200. The earthing module also comprises a trigger unit of a fast earthing switch 210. The photovoltaic cell is configured to generate the electrical energy required to activate the trigger unit on the basis of radiation from an arc event associated with a conductor of a medium voltage or high voltage switchgear. The reed contact 20, 220, 230, 240 within the short circuit detection circuit is configured to close when a magnitude of the current through the conductor associated with the arc event exceeds the threshold current value. Closure of the reed contact within the short circuit detection circuit is configured to close a circuit 250 such that the photovoltaic cell is configured to activate the trigger unit.

According to an example, the trigger unit comprises a micro gas generator or a spring system. Activation of the trigger unit is configured to release gas or activate a spring to move a connector to make an electrical connection between the conductor and earth potential.

According to an example, the earthing module comprises three short circuit detection devices each associated with a different one of three conductors of a three phase system. One or more of the three reed contacts 220, 230, 240 within one or more of the three short circuit detection circuits is configured to close when a magnitude of the current through one or more of the three conductors associated with the arc event exceeds the threshold current value. Activation of the trigger unit is configured to release gas or activate one or more springs to move one or more of three connectors to make an electrical connection between one or more of the three conductors and earth potential.

According to an example, activation of the trigger unit is configured to release gas or activate springs to move the three connectors to make an electrical connection between the three conductors and earth potential.

As discussed above, a switchgear can have one or more of the above described short circuit detection devices and/or one or more of the above described earthing modules.

Thus, reed contacts in the vicinity of the primary conductors are used to detect a current having a higher value than a pre-defined triggering value. Used in combination with a photovoltaic cell, that detects the light of the internal arc and generates the energy for releasing a protective device, a very simple arc protection system can be realised that does not require auxiliary power.

Continuing with the figures, several embodiments are now described in detail.

Fig. 1 shows a current that may run through the conductor 10 with the direction 11. The current is generating a magnetic field around the conductor in the direction indicated by the arrows 12. A reed contact 20 basically consists of a glass envelope 21, where an electrical contact is located, and two terminals 22. Two wires 23 can be added, for example by soldering, for the secondary connection of the reed contact. The reed contact is sensitive to magnetic fields in its longitudinal direction, therefore the orientation shown in Fig. 1 is the most sensitive with respect to current flowing in the conductor 10.

When the current reaches a certain threshold, it will generate a corresponding magnetic field, and the reed contact will therefore close. This can be evaluated for further actions, for example for releasing an earthing switch.

For the adjustment of the current threshold, four independent methods can be utilised, that can also be combined:

### Intrinsic sensitivity of the reed contact

Reed contacts are available off the shelf with a wide range of sensitivities, but also with a relatively small sensitivity tolerance for a certain type. For a certain application, a suitable type of reed contact can therefore be selected.

### Distance of the reed contact to the conductor

The strength of the magnetic field decreases with increasing distance to the centre of the conductor. Therefore, the current threshold can be adjusted by selection of the distance of the reed contact to the centre of the conductor, as shown in Fig. 2. The sensor at location 32 results in a higher current threshold than the sensor at the location 31, i.e. more current is required to generate a magnetic field that is suitable for operating the reed contact at the location 32 compared to a sensor at the location 31.

### Angle of the reed contact to the magnetic field

Location 33 in Fig. 2 shows a rotation of the reed contact. This turns the magnetically sensitive axis of the contact away from the main direction of the magnetic field, so that the current threshold will be increased, i.e. more current is required to generate a magnetic field that is suitable for operating the reed contact at the location 33 compared to a reed contact at the location 31.

### Usage of ferromagnetic shields

Fig. 2 further shows a ferromagnetic shield 40. Ferromagnetic parts attract magnetic fields from their non-ferromagnetic vicinity, so that the presence and dimensions of 40 increases the current threshold of the corresponding reed contact at position 34, i.e. with a shield 40, more current is required to generate a magnetic field that is suitable for operating the reed contact behind the shield 40 compared to the situation without the shield 40.

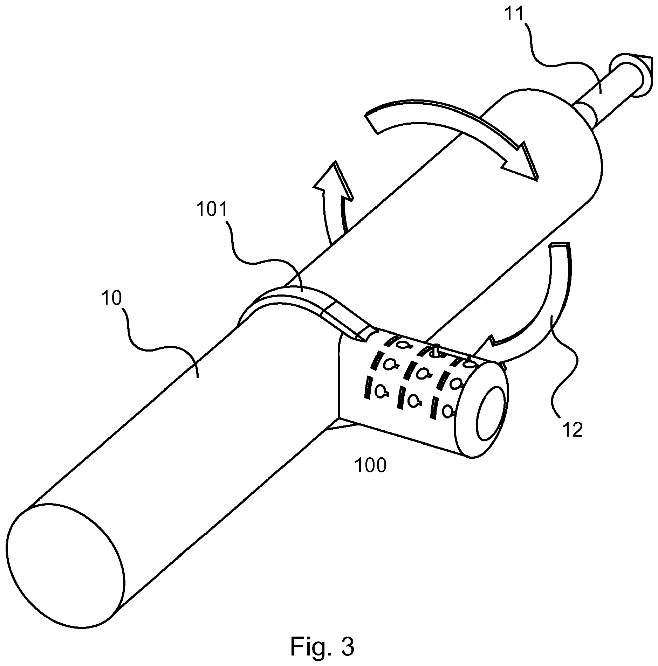

Fig. 3 shows a realisation of the discussed options, where a reed contact holder 100 is utilized. Fig. 3 shows the contact holder 100 that provides options to host a reed contact at different distances to the conductor, and at different angles, and with the option to insert a ferromagnetic shield. The holder 100 can for example be made from thermoplastic material or from epoxy. After insertion of the reed contact and optionally the shield, the remaining openings can be closed with self-locking plugs, having for example a snap fit, to avoid the reed contact or the shield moving or vibrating or falling out. Optionally, the reed contact and the shield can be fixed with glue.

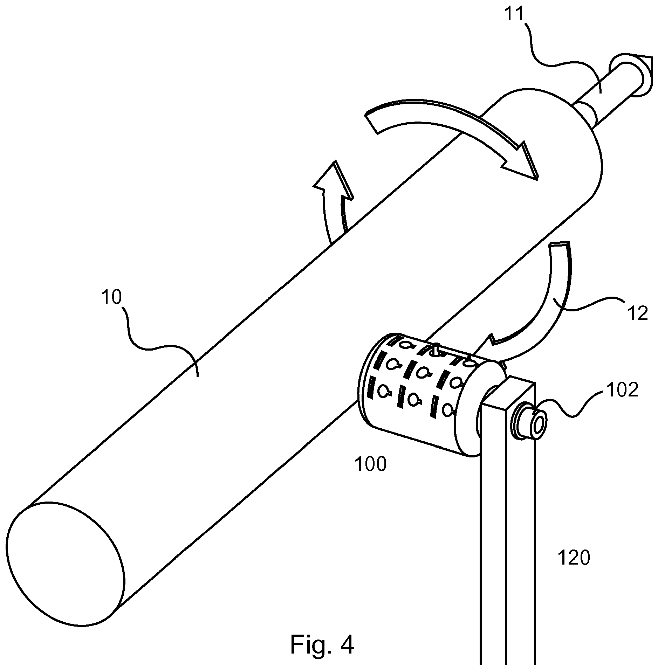

In case the conductor 100 has an earthed layer, the holder 100 can directly be fixed to the conductor, for example using a clamp 101, as shown in Fig. 3. If the conductor 100 is not insulated, or if an additional creepage path shall be avoided, the holder 100 can be fixed to a supporting structure 120 in the vicinity of the conductor, for example using a screw fixation 102, as shown in Fig. 4. The supporting structure 120 can also be the wall of a gas insulated switchgear GIS compartment.

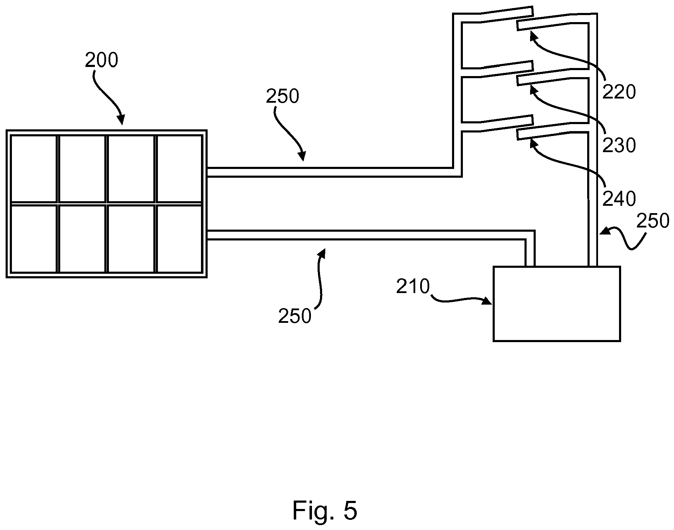

In combination with a stored energy fast earthing switch for internal arc protection and a photovoltaic cell, reed contacts offer a simple way of triggering the earthing switch without the need for auxiliary energy. Fig. 5 shows this in principle. In the situation where an internal arc fault occurs, the light of the arc will generate the required energy in the photovoltaic cell 200. At the same time one of the three currents of a three phase system is above the adjusted triggering value, the electrical circuit 250 is closed by one or more reed contacts 220, 230, 240 that are connected in parallel, and the electrical energy can arrive at the trip unit 210 of the stored energy fast earthing switch. The trip unit 210 can for example be a micro gas generator.

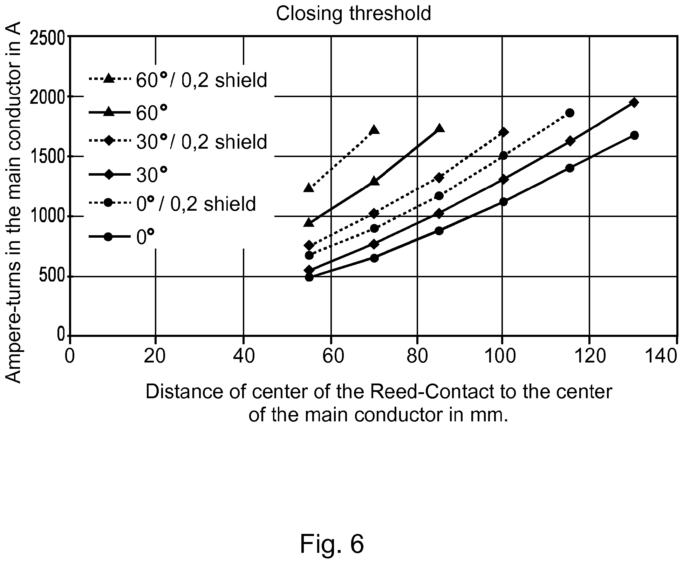

Fig. 6 shows the closing threshold of a reed contact, with and without a ferromagnetic shield, at different angles to the longitudinal axis of a conductor, as a function of lateral distance from the longitudinal axis of the conductor. This indicates how a reed contact can be positioned with respect to a conductor in order to provide a required threshold trigger level as required.

### Reference Numerals

10 Conductor
11 Direction of current flowing through 10
12 Direction of magnetic field due to 11
20 Reed contact
21 Glass envelope of 20
22 Terminals of 20
23 Connection wire of 20
31 First position of reed contact
32 Second position of reed contact
33 Third position of reed contact
34 Fourth position of reed contact
40 Ferromagnetic shield
100 Reed contact holder
101 Clamp fixation
102 Screw fixation
120 Supporting structure
200 Photovoltaic cell
210 Triggering unit of fast earthing switch
220 Reed contact of first phase
230 Reed contact of second phase
240 Reed contact of third phase
250 Electrical circuit

While the invention has been illustrated and described in detail in the drawings and foregoing description, such illustration and description are to be considered illustrative or exemplary and not restrictive. The invention is defined by the appended claims.

## Claims

1. A short circuit current detection device for a medium voltage or high voltage switchgear, the short circuit current detection device comprising:
- a reed contact (20); and
- a holder (100);
wherein, the holder is configured to hold the reed contact;
wherein, the holder is configured to be mounted with a defined orientation to a conductor of a switchgear, wherein at a location where the holder is mounted the conductor has a longitudinal axis and wherein the conductor is configured to enable a current to flow through the conductor in a direction of the longitudinal axis;
wherein the holder comprises a plurality of holes configured to enable the reed contact to be held at a plurality of distances from the longitudinal axis; and
wherein, the holder is configured to position the reed contact with respect to the longitudinal axis, such that when a magnitude of the current flow through the conductor exceeds a threshold current value the reed contact is configured to close.

2. Short circuit current detection device according to claim 1, wherein the threshold current value at which the reed contact is configured to close is based at least in part on an intrinsic sensitivity of the reed contact.

3. Short circuit current detection device according to any of claims 1-2, wherein the threshold current value at which the reed contact is configured to close is based at least in part on a magnitude of a distance perpendicular to the longitudinal axis at which the reed contact is positioned.

4. Short circuit current detection device according to any of claims 1-3, wherein the reed contact has a centre axis, and wherein the threshold current value at which the reed contact is configured to close is based at least in part on a magnitude of at least one angle between the longitudinal axis and the centre axis.

5. Short circuit current detection device according to claim 4, wherein an angle of the at least one angle is measured in a direction of an axis perpendicular to the longitudinal axis.

6. Short circuit current detection device according to claim 5, wherein the threshold current value at which the reed contact is configured to close is configured to increase as the magnitude of the angle increases from an orientation perpendicular to the axis perpendicular to the longitudinal axis.

7. Short circuit current detection device according to any of claims 4-6, wherein an angle of the at least one angle is measured in a direction of an axis parallel to the longitudinal axis.

8. Short circuit current detection device according to claim 7 wherein the threshold current value at which the reed contact is configured to close is configured to increase as the magnitude of the angle increases from an orientation perpendicular to the axis parallel to the longitudinal axis.

9. Short circuit current detection device according to any of claims 1-8, wherein the short circuit detection device comprises a ferromagnetic shield, and wherein the threshold current value at which the reed contact is configured to close is based at least in part on whether the ferromagnetic shield is positioned between the reed contact and the conductor.

10. Short circuit current detection device according to claim 9 wherein the threshold current value at which the reed contact is configured to close is based at least in part on at least one characteristic of the ferromagnetic shield (40).

11. Short circuit current detection device according to claim 10 wherein the at least one characteristic of the ferromagnetic shield comprises one or more of: thickness, width, length, material.

12. Short circuit current detection device according to any of claims 1-11, wherein the reed contact has a centre axis, and wherein the holder comprises a plurality of holes configured to enable the centre axis of the reed contact to be held at a plurality of angles with respect to the longitudinal axis.

13. Short circuit current detection device according to any of claims 1-12, wherein the holder comprises a plurality of slots configured to enable the optional insertion of a ferromagnetic shield between the conductor and the provided holes for holding the reed contact.

14. Short circuit current detection device according to any of claims 1-13, wherein the holder comprises means of fixation directly to the conductor so that the holder can be fixed with a defined orientation to the conductor.

15. Short circuit current detection device according to any of claims 1-14, wherein the holder comprises means of fixation at the surrounding structure of the switchgear so that the holder can be fixed with a defined orientation to the conductor.

16. An earthing module for a medium voltage or high voltage switchgear, the earthing module comprising:
- a short circuit current detection device according to any of claims 1-15; and
- a photovoltaic cell (200); and
- a trigger unit of a fast earthing switch (210);
wherein, the photovoltaic cell is configured to generate the electrical energy required to activate the trigger unit on the basis of radiation from an arc event associated with a conductor of a medium voltage or high voltage switchgear;
wherein, the reed contact (20, 220, 230, 240) within the short circuit detection circuit is configured to close when a magnitude of the current through the conductor associated with the arc event exceeds the threshold current value, and
wherein, closure of the reed contact within the short circuit detection circuit is configured to close a circuit (250) such that the photovoltaic cell is configured to activate the trigger unit.

17. Earthing module according to claim 16, wherein the trigger unit comprises a micro gas generator or spring system, and wherein activation of the trigger unit is configured to release gas or activate a spring to move a connector to make an electrical connection between the conductor and earth potential.

18. Earthing module according to claim 17, wherein the earthing module comprises three short circuit current detection devices each associated with a different one of three conductors of a three phase system, and wherein one or more of the three reed contacts (220, 230, 240) within one or more of the three short circuit detection circuits is configured to close when a magnitude of the current through one or more of the three conductors associated with the arc event exceeds the threshold current value, and wherein activation of the trigger unit is configured to release gas or activate one or more springs to move one or more of three connectors to make an electrical connection between one or more of the three conductors and earth potential.

19. Earthing module according to claim 18, wherein activation of the trigger unit is configured to release gas or activate springs to move the three connectors to make an electrical connection between the three conductors and earth potential.

20. A switchgear comprising one or more short circuit current detection devices according to any of claims 1-15.

21. A switchgear comprising one or more earthing modules according to any of claims 16-19.

## Patentansprüche

1. Kurzschlussstromdetektionseinrichtung für eine Mittelspannungs- oder Hochspannungsschaltanlage, wobei die Kurzschlussdetektionseinrichtung umfasst:
- einen Reed-Kontakt (20); und
- eine Halterung (100);
wobei die Halterung ausgelegt ist zum Halten des Reed-Kontakts;
wobei die Halterung ausgelegt ist zum Montiertwerden mit einer definierten Orientierung zu einem Leiter einer Schaltanlage, wobei an einem Ort, wo die Halterung montiert ist, der Leiter eine Längsachse aufweist und wobei der Leiter ausgelegt ist zum Ermöglichen des Fließens eines Stroms durch den Leiter in einer Richtung der Längsachse;
wobei die Halterung ausgelegt ist zum Positionieren des Reed-Kontakts bezüglich der Längsachse, so dass, wenn eine Größe des Stromflusses durch den Leiter einen Schwellwertstromwert übersteigt, der Reed-Kontakt ausgelegt ist zum Schließen.

2. Kurzschlussstromdetektionseinrichtung nach Anspruch 1, wobei der Schwellwertstromwert, bei dem der Reed-Kontakt ausgelegt ist zu schließen, mindestens teilweise auf einer intrinsischen Empfindlichkeit des Reed-Kontakts basiert.

3. Kurzschlussstromdetektionseinrichtung nach einem der Ansprüche 1-2, wobei der Schwellwertstromwert, bei dem der Reed-Kontakt ausgelegt ist zu schließen, mindestens teilweise auf einer Größe einer Distanz senkrecht zu der Längsachse basiert, unter der der Reed-Kontakt positioniert ist.

4. Kurzschlussstromdetektionseinrichtung nach einem der Ansprüche 1-3, wobei der Reed-Kontakt eine Mittelachse aufweist und wobei der Schwellwertstromwert, bei dem der Reed-Kontakt ausgebildet ist zu schließen, mindestens teilweise auf einer Größe mindestens eines Winkels zwischen der Längsachse und der Mittelachse basiert.

5. Kurzschlussstromdetektionseinrichtung nach Anspruch 4, wobei ein Winkel des mindestens einen Winkels in eine Richtung einer Achse senkrecht zu der Längsachse gemessen wird.

6. Kurzschlussstromdetektionseinrichtung nach Anspruch 5, wobei der Schwellwertstromwert, bei dem der Reed-Kontakt ausgelegt ist zu schließen, ausgelegt ist zum Zunehmen, während die Größe des Winkels von einer Orientierung senkrecht zu der Achse senkrecht zu der Längsachse zunimmt.

7. Kurzschlussstromdetektionseinrichtung nach einem der Ansprüche 4-6, wobei ein Winkel des mindestens einen Winkels in einer Richtung einer Achse parallel zu der Längsachse gemessen wird.

8. Kurzschlussstromdetektionseinrichtung nach Anspruch 7, wobei der Schwellwertstromwert, bei dem der Reed-Kontakt ausgelegt ist zu schließen, ausgelegt ist zum Zunehmen, während die Größe des Winkels von einer Orientierung senkrecht zu der Achse parallel zu der Längsachse zunimmt.

9. Kurzschlussstromdetektionseinrichtung nach einem der Ansprüche 1-8, wobei die Kurzschlussdetektionseinrichtung ein ferromagnetisches Schild umfasst und wobei der Schwellwertstromwert, bei dem der Reed-Kontakt ausgelegt ist zu schließen, mindestens teilweise darauf basiert, ob das ferromagnetische Schild zwischen dem Reed-Kontakt und dem Leiter positioniert ist.

10. Kurzschlussstromdetektionseinrichtung nach Anspruch 9, wobei der Schwellwertstromwert, bei dem der Reed-Kontakt ausgelegt ist zu schließen, mindestens teilweise auf mindestens einer Charakteristik des ferromagnetischen Schilds (40) basiert.

11. Kurzschlussstromdetektionseinrichtung nach Anspruch 10, wobei die mindestens eine Charakteristik des ferromagnetischen Schilds eine oder mehrere von Dicke, Breite, Länge, Material umfasst.

12. Kurzschlussstromdetektionseinrichtung nach einem der Ansprüche 1-11, wobei der Reed-Kontakt eine Mittelachse aufweist und wobei die Halterung mehrere Löcher umfasst, ausgelegt zu ermöglichen, dass die Mittelachse des Reed-Kontakts unter mehreren Winkeln bezüglich der Längsachse gehalten wird.

13. Kurzschlussstromdetektionseinrichtung nach einem der Ansprüche 1-12, wobei die Halterung mehrere Schlitze umfasst, die ausgelegt sind, das optionale Einsetzen eines ferromagnetischen Schilds zwischen dem Leiter und den vorgesehenen Löchern zum Halten des Reed-Kontakts zu ermöglichen.

14. Kurzschlussstromdetektionseinrichtung nach einem der Ansprüche 1-13, wobei die Halterung Mittel zur Fixierung direkt an dem Leiter umfasst, so dass die Halterung mit einer definierten Orientierung zu dem Leiter fixiert werden kann.

15. Kurzschlussstromdetektionseinrichtung nach einem der Ansprüche 1-14, wobei die Halterung Mittel zur Fixierung an der umgebenden Struktur der Schaltanlage umfasst, so dass die Halterung mit einer definierten Orientierung zu dem Leiter fixiert werden kann.

16. Erdungsmodul für eine Mittelspannungs- oder Hochspannungsschaltanlage, wobei das Erdungsmodul umfasst:
- eine Kurzschlussstromdetektionseinrichtung nach einem der Ansprüche 1-15; und
- eine photovoltaische Zelle (200); und
- eine Auslöseeinheit eines schnellen Erdungsschalters (210);
wobei die photovoltaische Zelle ausgelegt ist zum Erzeugen der elektrischen Energie, die erforderlich ist, um die Auslöseeinheit zu aktivieren, auf Basis von Strahlung von einem Lichtbogenereignis, das mit einem Leiter einer Mittelspannungs- oder Hochspannungsschaltanlage assoziiert ist;
wobei der Reed-Kontakt (20, 220, 230, 240) innerhalb der Kurzschlussdetektionsschaltung ausgelegt ist zu schließen, wenn eine Größe des Stroms durch den Leiter, mit dem Lichtbogenereignis assoziiert, den Schwellwertstromwert übersteigt, und
wobei eine Schließung des Reed-Kontakts innerhalb der Kurzschlussdetektionsschaltung ausgelegt ist zum Schließen eines Stromkreises (250), so dass die photovoltaische Zelle ausgelegt ist zum Aktivieren der Auslöseeinheit.

17. Erdungsmodul nach Anspruch 16, wobei die Auslöseeinheit ein Mikrogasgenerator- oder -federsystem umfasst, und wobei eine Aktivierung der Auslöseeinheit ausgelegt ist zum Freigeben von Gas oder Aktivieren einer Feder zum Bewegen eines Verbinders zum Herstellen einer elektrischen Verbindung zwischen dem Leiter und Erdpotential.

18. Erdungsmodul nach Anspruch 17, wobei das Erdungsmodul drei Kurzschlussstromdetektionseinrichtungen umfasst, die jeweils mit einem anderen der drei Leiter eines Dreiphasensystems assoziiert sind, und wobei einer oder mehrere der drei Reed-Kontakte (220, 230, 240) innerhalb einer oder mehrerer der drei Kurzschlussdetektionsschaltungen ausgelegt ist zu schließen, wenn eine Größe des Stroms durch einen oder mehrere der drei Leiter, mit dem Lichtbogenereignis assoziiert, den Schwellwertstromwert übersteigt, und wobei eine Aktivierung der Auslöseeinheit ausgelegt ist zum Freigeben von Gas oder Aktivieren einer oder mehrerer Federn zum Bewegen eines oder mehrerer der drei Verbinder zum Herstellen einer elektrischen Verbindung zwischen einem oder mehreren der drei Leiter und Erdpotential.

19. Erdungsmodul nach Anspruch 18, wobei eine Aktivierung der Auslöseeinheit ausgelegt ist zum Freigeben von Gas oder Aktivieren von Federn zum Bewegen der drei Verbinder zum Herstellen einer elektrischen Verbindung zwischen den drei Leitern und Erdpotential.

20. Schaltanlage umfassend eine oder mehrere Kurzschlussstromdetektionseinrichtungen nach einem der Ansprüche 1-15.

21. Schaltanlage umfassend ein oder mehrere Erdungsmodule nach einem der Ansprüche 16-19.

## Revendications

1. Dispositif de détection de courant de court-circuit pour un appareillage moyenne tension ou haute tension, le circuit de détection de court-circuit comprenant :
- un contact à lames souples (20) ; et
- un élément de maintien (100) ;
l'élément de maintien étant configuré pour maintenir le contact à lames souples ;
l'élément de maintien étant configuré pour être monté avec une orientation définie par rapport à un conducteur (10) d'un appareillage ; à un emplacement de montage de l'élément de maintien, le conducteur présentant un axe longitudinal et le conducteur étant configuré pour permettre la circulation d'un courant dans le conducteur dans une direction de l'axe longitudinal ;
l'élément de maintien comprenant une pluralité de trous configurés pour permettre le maintien du contact à lames souples à une pluralité de distances de l'axe longitudinal ; et
l'élément de maintien étant configuré pour positionner le contact à lames souples par rapport à l'axe longitudinal, de sorte que, lorsqu'une grandeur du courant circulant dans le conducteur dépasse une valeur-seuil de courant, le contact à lames souples soit configuré pour se fermer.

2. Dispositif de détection de courant de court-circuit selon la revendication 1, dans lequel la valeur-seuil de courant à laquelle le contact à lames souples est configuré pour se fermer est basée au moins en partie sur une sensibilité intrinsèque du contact à lames souples.

3. Dispositif de détection de courant de court-circuit selon l'une quelconque des revendications 1 à 2, dans lequel la valeur-seuil de courant à laquelle le contact à lames souples est configuré pour se fermer est basée au moins en partie sur une grandeur d'une distance perpendiculaire à l'axe longitudinal à laquelle le contact à lames souples est positionné.

4. Dispositif de détection de courant de court-circuit selon l'une quelconque des revendications 1 à 3, dans lequel le contact à lames souples présente un axe central, et dans lequel la valeur-seuil de courant à laquelle le contact à lames souples est configuré pour se fermer est basée au moins en partie sur une grandeur d'au moins un angle entre l'axe longitudinal et l'axe central.

5. Dispositif de détection de courant de court-circuit selon la revendication 4, dans lequel un angle de l'au moins un angle est mesuré dans une direction d'un axe perpendiculaire à l'axe longitudinal.

6. Dispositif de détection de courant de court-circuit selon la revendication 5, dans lequel la valeur-seuil de courant à laquelle le contact à lames souples est configuré pour se fermer est configurée pour augmenter à mesure que la grandeur de l'angle augmente à partir d'une orientation perpendiculaire à l'axe perpendiculaire à l'axe longitudinal.

7. Dispositif de détection de courant de court-circuit selon l'une quelconque des revendications 4 à 6, dans lequel un angle de l'au moins un angle est mesuré dans une direction d'un axe parallèle à l'axe longitudinal.

8. Dispositif de détection de courant de court-circuit selon la revendication 7, dans lequel la valeur-seuil de courant à laquelle le contact à lames souples est configuré pour se fermer est configurée pour augmenter à mesure que la grandeur de l'angle augmente à partir d'une orientation perpendiculaire à l'axe parallèle à l'axe longitudinal.

9. Dispositif de détection de courant de court-circuit selon l'une quelconque des revendications 1 à 8, lequel dispositif de détection de court-circuit comprend un blindage ferromagnétique, et dans lequel la valeur-seuil de courant à laquelle le contact à lames souples est configuré pour se fermer est basée au moins en partie sur le fait que le blindage ferromagnétique est positionné ou non entre le contact à lames souples et le conducteur.

10. Dispositif de détection de courant de court-circuit selon la revendication 9, dans lequel la valeur-seuil de courant à laquelle le contact à lames souples est configuré pour se fermer est basée au moins en partie sur au moins une caractéristique du blindage ferromagnétique (40) .

11. Dispositif de détection de courant de court-circuit selon la revendication 10, dans lequel l'au moins une caractéristique du blindage ferromagnétique comprend : l'épaisseur et/ou la largeur et/ou la longueur et/ou le matériau.

12. Dispositif de détection de courant de court-circuit selon l'une quelconque des revendications 1 à 11, dans lequel le contact à lames souples présente un axe central, et dans lequel l'élément de maintien comprend une pluralité de trous configurés pour permettre le maintien de l'axe central du contact à lames souples à une pluralité d'angles par rapport à l'axe longitudinal.

13. Dispositif de détection de courant de court-circuit selon l'une quelconque des revendications 1 à 12, dans lequel l'élément de maintien comprend une pluralité de fentes configurées pour permettre l'insertion éventuelle d'un blindage ferromagnétique entre le conducteur et les trous ménagés pour maintenir le contact à lames souples.

14. Dispositif de détection de courant de court-circuit selon l'une quelconque des revendications 1 à 13, dans lequel l'élément de maintien comprend un moyen de fixation directement sur le conducteur de façon à permettre la fixation de l'élément de maintien avec une orientation définie par rapport au conducteur.

15. Dispositif de détection de courant de court-circuit selon l'une quelconque des revendications 1 à 14, dans lequel l'élément de maintien comprend un moyen de fixation au niveau de la structure environnante de l'appareillage de façon à permettre la fixation de l'élément de maintien avec une orientation définie par rapport au conducteur.

16. Module de mise à la terre pour un appareillage moyenne tension ou haute tension, le module de mise à la terre comprenant :
- un dispositif de détection de courant de court-circuit selon l'une quelconque des revendications 1 à 15 ; et
- une cellule photovoltaïque (200) ; et
- une unité de déclenchement d'un sectionneur de mise à la terre rapide (210) ;
la cellule photovoltaïque étant configurée pour générer l'énergie électrique nécessaire à l'activation de l'unité de déclenchement sur la base d'un rayonnement émanant d'un événement d'arc associé à un conducteur d'un appareillage moyenne tension ou haute tension ;
le contact à lames souples (20, 220, 230, 240) à l'intérieur du circuit de détection de court-circuit étant configuré pour se fermer lorsqu'une grandeur du courant circulant dans le conducteur associé à l'événement d'arc dépasse la valeur-seuil de courant, et
la fermeture du contact à lames souples au sein du circuit de détection de court-circuit étant configurée pour fermer un circuit (250) de sorte que la cellule photovoltaïque soit configurée pour activer l'unité de déclenchement.

17. Module de mise à la terre selon la revendication 16, dans lequel l'unité de déclenchement comprend un micro-générateur de gaz ou un système à ressort, et dans lequel l'activation de l'unité de déclenchement est configurée pour libérer du gaz ou activer un ressort pour amener un connecteur à établir une connexion électrique entre le conducteur et le potentiel de la terre.

18. Module de mise à la terre selon la revendication 17, lequel module de mise à la terre comprend trois dispositifs de détection de courant de court-circuit dont chacun est associé à un conducteur différent parmi trois conducteurs d'un système triphasé, et dans lequel un ou plusieurs des trois contacts à lames souples (220, 230, 240) au sein d'un ou de plusieurs des trois circuits de détection de court-circuit sont configurés pour se fermer lorsqu'une grandeur du courant circulant dans un ou plusieurs des trois conducteurs associés à l'événement d'arc dépasse la valeur-seuil de courant, et dans lequel l'activation de l'unité de déclenchement est configurée pour libérer du gaz ou activer un ou plusieurs ressorts pour amener un ou plusieurs de trois connecteurs à établir une connexion électrique entre un ou plusieurs des trois conducteurs et le potentiel de la terre.

19. Module de mise à la terre selon la revendication 18, dans lequel l'activation de l'unité de déclenchement est configurée pour libérer du gaz ou activer des ressorts pour amener les trois connecteurs à établir une connexion électrique entre les trois conducteurs et le potentiel de la terre.

20. Appareillage, comprenant un ou plusieurs dispositifs de détection de courant de court-circuit selon l'une quelconque des revendications 1 à 15.

21. Appareillage, comprenant un ou plusieurs modules de mise à la terre selon l'une quelconque des revendications 16 à 19.
